# EUROPEAN PATENT SPECIFICATION

(11) **EP 4 389 422 B1**
(45) Date of publication and mention of the grant of the patent: **27.08.2025**
(21) Application number: 23219535.4
(22) Date of filing: 21.12.2023
(51) Int. Cl.: B32B 37/06, B30B 5/02, H10F 19/80, H10F 71/00

(54) **LAMINATOR APPARATUS WITH LOWER AND UPPER HEATING SYSTEM WITH FLAT HEATERS**
LAMINIERVORRICHTUNG MIT EINEM OBER- UND UNTERHEIZSYSTEM MIT FLACHEN HEIZELEMENTEN
APPAREIL DE LAMINAGE AVEC SYSTÈME DE CHAUFFAGE INFÉRIEUR ET SUPÉRIEUR AVEC ÉLÉMENTS DE CHAUFFAGE PLATS

(30) Priority: 22.12.2022 IT 202200026610
(43) Date of publication of application: 26.06.2024
(73) Proprietor: Ecoprogetti S.R.L., 35010 Carmignano di Brenta (PD) (IT)
(72) Inventor: SARTORE, Domenico, 35010 Carmignano di Brenta (PD) (IT); GONZATO, Eugenio, 35010 Carmignano di Brenta (PD) (IT); PASTORE, Guido, 35043 Monselice (PD) (IT); ANDRETTA, Nicola, 35013 Cittadella (PD) (IT)
(74) Representative: Petraz, Gilberto Luigi

(56) References cited:
- DE-A1- 102008 018 895
- DE-A1- 102011 112 582
- JP-A- 2015 112 635

## Description

### FIELD OF THE INVENTION

The present invention concerns a laminator apparatus with lower and upper heating system with flat heaters, which is configured to laminate an object formed by a sandwich of various materials, making it become, through a thermal and pneumatic-mechanical action, a single body. In particular, the laminator apparatus is particularly suitable for subjecting photovoltaic modules, or panels, to lamination.

### BACKGROUND OF THE INVENTION

In the sector of photovoltaic panel production, it is known that a photovoltaic panel, after being created with a sandwich of various materials, including glass, encapsulating material, with photovoltaic strings interposed, before undergoing subsequent finishing, framing and electronic connection operations, has to undergo a hot lamination process in order to become a single laminated body.

This process is carried out by means of a laminator apparatus that generally comprises two lamination platforms that face each other, with a flexible membrane interposed.

A first lower platform constitutes a support system for one or more photovoltaic panels disposed in alternative ways, typically side-by-side. A second upper platform can be moved, by means of lifting cylinders, typically of the hydraulic type, toward the lower platform, determining an enclosed space inside which both a thermal as well as a pressure load is applied.

The lower platform comprises a frame on which a certain number of flat heating units are mounted, functional for supporting the panels, aligned along the length of the laminator apparatus.

Each flat heating unit typically consists of a plate provided with heating means, which are typically immovable or in any case difficult to separate from the plate itself.

The heating means are typically tubular electric resistance heaters, or a tube system inside which a heated recirculation fluid, usually oil, can flow.

Heating with recirculation fluid has some disadvantages, substantially linked to the greater power required, a slow induced heating of the plates, higher thermal losses, long times and high costs for maintenance, periodic replacement and disposal, which can be avoided with tubular electric heaters.

Tubular electric heaters are equally disadvantageous, because a considerable number of them is required to effectively heat the plates on which the respective photovoltaic panels are disposed. In addition, the direct thermal contact surface that is determined will inevitably be reduced to a series of thin lines or strips that can easily cause thermal non-uniformities on the plates, with consequent thermal stresses and warping thereof.

There are also laminator apparatuses in which the upper platform is also able to determine a thermal action on the photovoltaic panels. In these solutions, instead of the membrane, there is a thermal cushion inside which a series of heating elements is incorporated.

This solution involves some disadvantages, linked to the complex maintenance and replacement of the individual elements without having to replace the entire thermal pad, and to the difficulty of ensuring the thermal cushion adapts with a uniform pressure on the photovoltaic panel. Furthermore, since the thermal pad itself contains the heating elements, its complete replacement is more onerous than the solutions with a membrane.

There is therefore the need to perfect a laminator apparatus with lower and upper heating system that can overcome at least one of the disadvantages of the state of the art.

One purpose of the present invention, which corresponds to the technical problem we intend to resolve, is to provide a laminator apparatus capable of supplying a particularly uniform thermal heating both at the lower part and also at the upper part on the photovoltaic panels being worked, thus increasing the quality of the final product.

Another purpose of the present invention is to provide a laminator apparatus that comprises lamination plates that are optimized to achieve particularly reactive heating transients.

Another purpose of the present invention is to provide a laminator apparatus that is more economical, both in terms of production as well as management costs.

The Applicant has devised, tested and embodied the present invention to overcome the shortcomings of the state of the art and to obtain these and other purposes and advantages.

A laminator apparatus according to the background art is disclosed in DE 10 2008 018895 A1.

### SUMMARY OF THE INVENTION

The present invention is set forth and characterized in the independent claim. The dependent claims describe other characteristics of the present invention or variants to the main inventive idea.

In accordance with the above purposes and to resolve the technical problem disclosed above in a new and original way, also achieving considerable advantages compared to the state of the prior art, the present invention concerns a laminator apparatus with lower and upper heating system with flat heaters, which is configured to laminate multi-layer objects, for example, but not only, photovoltaic modules or panels.

The laminator apparatus comprises a support structure on which there are mounted a first and a second lamination platform, which are advantageously horizontal and facing each other, with a flexible membrane interposed.

The first platform, disposed at the lower part, comprises a plurality of flat heating units on which at least one object to be laminated is able to be disposed.

In accordance with one aspect of the present invention, each of the flat heating units is formed by a pair of plates closed one on top of the other, between which there is inserted a plurality of electric resistance flat heaters.

Doing so maximizes the direct contact heat exchange surface, since the resistances are flat, rather than tubular as in the state of the art.

Moreover, the electric resistance flat heaters advantageously cover the entire area, or almost, of the plates, this allowing to minimize the non-uniformities from the thermal and structural point of view, as well as reduce the time linked to the heating transient of the plates themselves, since the area of the plates in direct contact with the electric resistance flat heaters is maximized. All this leads to greater temperature uniformity on the surface of the plate on which the object to be laminated rests.

In accordance with another aspect of the present invention, the plurality of electric resistance flat heaters can be easily removed from the pair of plates. This allows both to produce the flat hating units more easily, and also to rapidly carry out maintenance on, and replace, possible worn components.

In accordance with the present invention, each electric resistance flat heater is formed by a sandwich comprising at least two flat layers, electrically insulating and thermally conductive, between which at least one electrically powered conductive track is inserted.

In accordance with another aspect of the present invention, the at least two flat layers and the at least one conductive track constitute a single body which, in one embodiment, can be hermetically sealed or, in one variant, can be not sealed, in any case with the various layers constrained to each other.

In accordance with the present invention, one or more of the at least two flat layers and the at least one conductive track can be connected in a removable manner in order to be selectively separable.

In accordance with another aspect of the present invention, each electric resistance flat heater can comprise a plurality of distinct conductive tracks, electrically powered independently in order to obtain thermally differentiated zones.

In accordance with another aspect of the present invention, the second platform, disposed at the upper part, comprises a second frame with which there is associated a plurality of radiance heaters which is disposed facing the flexible membrane, which is constrained to the second platform, and therefore to the underlying objects to be laminated.

In accordance with another aspect of the present invention, the plurality of radiance heaters is attached to an upper internal wall of the second frame, possibly in a position that is distanced with respect to the upper internal wall, by means of support elements having an insulating and vibration compensation function. According to one variant, the radiance heaters are attached in direct contact with the upper internal wall. In a further variant, the radiance heaters are recessed in the upper internal wall.

In accordance with another aspect of the present invention, the upper platform comprises a flat grid element disposed between the plurality of radiance heaters and the flexible membrane. The grid element can be positioned up against the radiance heaters, and possibly integrated therewith, or slightly distanced.

In accordance with another aspect of the present invention, the grid element can be formed by a flat plate provided with a plurality of apertures. These apertures have advantageously a respective passage gap which is diversified one from the other, or which is the same for each one. Moreover, the distribution of the apertures on the plate can be either uniform or with a differentiated intensity in different zones of the plate.

### DESCRIPTION OF THE DRAWINGS

These and other aspects, characteristics and advantages of the present invention will become apparent from the following description of an embodiment, given as a non-restrictive example with reference to the attached drawings wherein:
- fig. 1 is a schematic lateral view of a laminator apparatus according to the present invention;
- figs. 2-3 are enlarged cross-section views of the laminator apparatus of fig. 1 in a configuration with open platforms (fig. 2) and closed platforms (fig. 3), respectively;
- fig. 4 is a schematic 3D view of a flat heating unit 24;
- fig. 5 is a schematic 3D view of an embodiment of an electric resistance flat heater;
- fig. 6 shows the sandwich of layers, which in this case are three, by way of example, which the electric resistance flat heater of fig. 5 consists of;
- fig. 7 is an enlarged detail that shows the grid element placed to cover a pair of radiance heaters;
- fig. 8 is a bottom view of a possible embodiment of the grid element of fig. 7.

We must clarify that the phraseology and terminology used in the present description, as well as the figures in the attached drawings also in relation as to how described, have the sole function of better illustrating and explaining the present invention, their purpose being to provide a non-limiting example of the invention itself, since the scope of protection is defined by the claims.

To facilitate comprehension, the same reference numbers have been used, where possible, to identify identical common elements in the drawings. It is understood that elements and characteristics of one embodiment can be conveniently combined or incorporated into other embodiments without further clarifications.

### DESCRIPTION OF AN EMBODIMENT OF THE PRESENT INVENTION

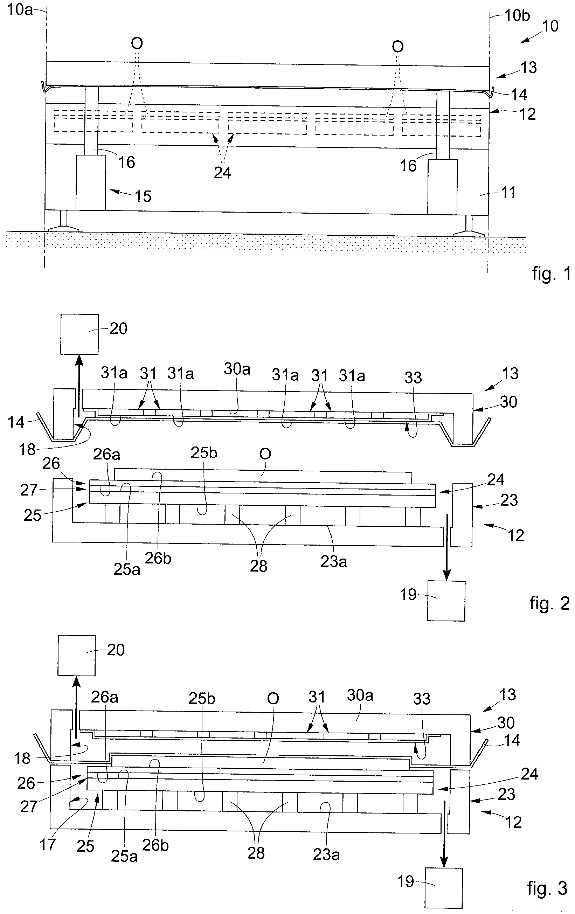

With reference to figs. 1-3, a laminator apparatus 10 according to the present invention is configured to subject multilayer objects, that is, formed by a sandwich of various materials, to lamination, making them become, through a thermal and pneumatic-mechanical action, a single laminated body.

Without limitation to generality, the laminator apparatus 10 is particularly suitable for subjecting photovoltaic modules, or panels, to lamination.

The laminator apparatus 10 comprises a support structure 11 on which there are mounted a first and a second lamination platform 12, 13 which are substantially horizontal and facing each other, with interposed a flexible membrane 14 removably associated with the second platform 13.

Both the first and also the second platform 12, 13 are configured to determine a thermal action on the objects to be laminated O.

The platforms 12, 13 extend from an inlet section 10a to an outlet section 10b of the laminator apparatus 10, fig. 1. The distance between the two inlet and outlet sections 10a, 10b defines an extension in length of the laminator apparatus 10.

A first, lower, platform 12 is able to support one or more objects to be laminated O, and a second, upper, platform 13 faces the first platform 12 and can be moved closer to/away from the latter by means of movement means 15 of a known type, for example hydraulic cylinders16, fig. 1.

When the two platforms 12, 13 are coupled in a closed configuration, the flexible membrane 14 determines a first hermetic lamination chamber 17 with the first platform 12, in which the objects to be laminated O are disposed, and a second hermetic lamination chamber 18 with the second platform 13, in a more or less hard vacuum condition, fig. 3.

The first lamination chamber 17 is separated from the second lamination chamber 18 by means of the aforementioned flexible membrane 14 and both are insulated, both one with respect to the other and also with respect to an environment outside the laminator apparatus 10, when the platforms 12, 13 are in a closed configuration.

Each one of the two lamination chambers 17, 18 is fluidically connected to a distinct suction device 19, 20 configured to generate the vacuum inside the respective lamination chamber 17, 18, or also to determine a positive pressure through the introduction of air, figs. 2-3.

Operationally, in the entry phase of the objects to be laminated O, the flexible membrane 14 is pressed against an upper internal wall 30a of the second platform 13, since the vacuum is created only in the second lamination chamber 18, while at the lower part there is air, since the platforms 12, 13 are still open, that is, distanced apart, fig. 2.

Once the loading of the objects to be laminated O has been completed, the closure of the platforms 12, 13 is started. The flexible membrane 14 remains adherent to the second platform 13, so as not to immediately press on the objects to be laminated O. With the platforms closed, a vacuum is then also created in the first lamination chamber 17; consequently, the flexible membrane 14 begins to lower until it rests on the objects to be laminated O. After a first phase with a vacuum in both lamination chambers 17, 18, air is introduced only inside the second lamination chamber 18; at this point, the flexible membrane 14 begins to press on the objects to be laminated O, adapting to their shape, fig. 3.

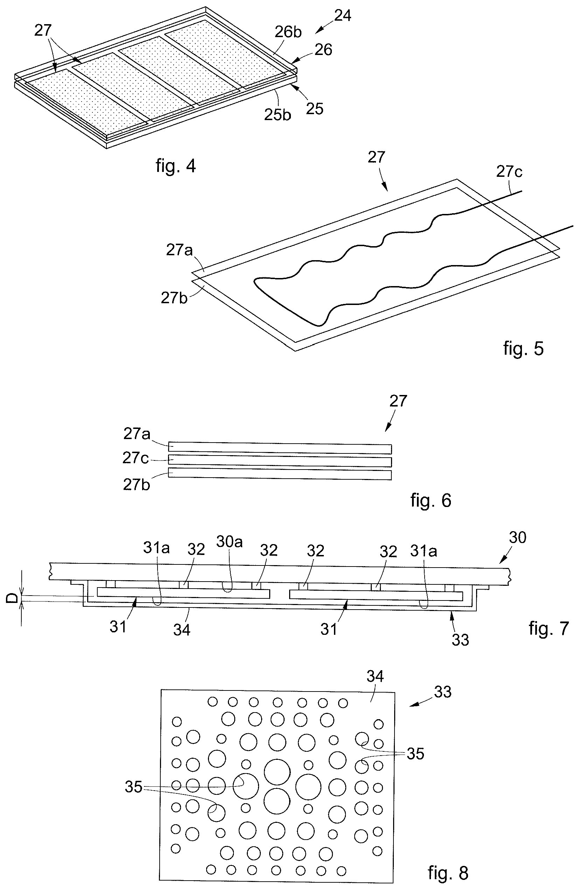

The first platform 12 comprises a first frame 23 supporting a plurality of flat heating units 24 (figs. 2-3) which are, by way of example, substantially rectangular in shape (fig. 4) and are configured to determine a heating of the objects to be laminated O, mainly by thermal conduction, that is, through contact.

The flat heating units 24 are coplanar with each other and disposed side-by-side, aligned in a direction that goes from the inlet section 10a to the outlet section 10b of the laminator apparatus 10, fig. 1.

A single object to be laminated O is preferably disposed on each flat heating unit 24 or, if the objects to be laminated O are large, these can be disposed on multiple contiguous flat heating units 24. The objects to be laminated O are positioned on the flat heating units 24 described below in an automated or manual manner, in a position comprised between the inlet section 10a and the outlet section 10b. According to possible embodiments, the flat heating units 24 can all be the same or they can be diversified according to thermal characteristics, depending on the position in which they are installed. For example, the outermost flat heating units 24, that is, the ones closest to the inlet and outlet sections 10a, 10b, can be the same as each other and different from the central ones.

Each flat heating unit 24 is formed by a pair of plates 25, 26 having a substantially horizontal flat development, closed one on the other, between which there is inserted a plurality of electric resistance flat heaters 27, figs. 2-4.

The electric resistance flat heaters 27 are preferably electrically powered and managed independently from each other.

The electric resistance flat heaters 27 cover, overall, a contact area substantially equal to a horizontal flat area of the plates 25, 26, fig. 4.

The plates 25, 26 are a lower plate 25 which is removably attached, with an attachment surface 25b thereof, to a bottom wall 23a of the first frame 23, and an upper plate 26 which is able to support at least one object to be laminated O or a support surface 26b thereof, figs. 2-3.

The plates 25, 26 have a conformation such as to uniformly compress the electric resistance flat heaters 27 guaranteeing, in particular, optimal contact between the latter and the upper plate 26.

The attachment surface 25b faces the bottom wall 23a and is provided with a plurality of supports 28, configured as support feet, which advantageously allow to limit the thermal bridges with the first frame 23, figs. 2-3.

The support surface 26b faces the second platform 13, that is, the flexible membrane 14, figs. 2-3.

Both plates 25, 26 also have two flat contact surfaces 25a, 26a, opposing the attachment surface 25b and the support surface 26b, respectively, between which the electric resistance flat heaters 27 are disposed in contact, figs. 2-3.

Each flat heating unit 24 is therefore divided into distinct and independent thermal control zones, typically corresponding to the number of electric resistance flat heaters 27 present.

Each electric resistance flat heater 27 can, in turn, have its own differentiated thermal control zones when it comprises more than one conductive track per single heater.

The electric resistance flat heaters 27 can be made with different geometries, depending on project requirements. In the example shown in figs. 4-5, the electric resistance flat heaters 27 are rectangular in shape.

Each electric resistance flat heater 27 is formed by a sandwich comprising at least two flat, thermally conductive and electrically insulating layers 27a, 27b, between which at least one electrically powered conductive track 27c is inserted. Current travels through the conductive track 27c and consequently generates heat by Joule effect, transferring it, through the flat layers 27a, 27b, to the plates 25, 26 with which they are in contact.

The path and the "density" of the conductive track 27c are design parameters that vary as a function of the heat required per area unit.

The conductive track 27c is constrained to at least one of the two flat layers 27a, 27b between which it is disposed.

The flat layers 27a, 27b can be made of materials having different characteristics. For example, the flat layer 27a in contact with the upper plate 26 can have better thermal transmissibility characteristics than the flat layer 27b in contact with the lower plate 25 in the direction of which heat conduction is not required, but rather an effect as insulating as possible.

In addition to the two flat layers 27a, 27b, further flat layers interspersed with further layers of conductive tracks can possibly also be present.

The layers 27a, 27b and the optional layers possibly present can be joined together in an immovable manner in order to create a hermetically sealed single body component.

The flat layers 27a, 27b and the further layers possibly present can also be separable from each other and with respect to the conductive track 27c, being therefore replaceable in the event of degradation of the materials. This advantageously allows each electric resistance flat heater 27 to be reconfigured without having to completely replace it, increasing its flexibility and reducing management/maintenance costs.

The conductive track 27c of each individual electric resistance flat heater 27 is typically unique, formed by a single continuous conductor with a first end, or pole, for the inlet of electric current and a second end, or pole, for the outlet of electric current, fig. 5.

In an alternative configuration, each electric resistance flat heater 27 can comprise more than one conductive track 27c, each one with its own current inlet and outlet ends. This advantageously allows each electric resistance flat heater 27 to be divided into several independent thermal zones corresponding to the number of conductive tracks 27c present.

According to the present invention, the second platform 13 comprises a second frame 30 with which there is associated a plurality of radiance heaters 31 with emitting flat surfaces 31a, capable of emitting electromagnetic radiation to determine a contactless heating of the flexible membrane 14 and of the objects to be laminated O, figs. 2-3.

The radiance heaters 31 are made of a very high emissivity material, preferably higher than 0.9 and necessarily lower than 1, in particular emitters with electromagnetic wavelengths in the Infrared band.

The radiance heaters 31 are attached to the upper internal wall 30a of the second frame 30, preferably in a position distanced with respect thereto, and face the membrane 14 and the object to be laminated O, figs. 2, 3 and 7.

The radiance heaters 31 are attached to the upper internal wall 30a by means of support elements 32, fig. 7.

The support elements 32 have both a spacer and an insulating function from the point of view of thermal conduction, to prevent the unwanted heating of the second frame 30 by helping to effectively direct the thermal flow in the direction of the objects to be laminated O, as well as a function of compensating for the thermal expansions, but also a function of compensating for the vibrations that may be generated during the closure of the platforms 12, 13.

The second platform 13 comprises at least one flat grid element 33 provided with apertures 35 with advantageously variable geometry, the grid element 33 being disposed between the radiance heaters 31 and the flexible membrane 14, figs. 2, 3 and 7. This advantageously allows to prevent a thermal damage of the flexible membrane 14 in case of direct contact with the radiance heaters 31.

The grid element 33 is attached to the upper internal wall 30a, covering the radiance heaters 31 figs. 2, 3 and 7.

The grid element 33 is located at a suitable distance D, of the order of a few millimeters, with respect to the emitting flat surfaces 31a of the radiance heaters 31, so as to overheat in a limited manner and cool more rapidly when the platforms 12, 13 open at the end of the lamination cycle fig. 7.

The grid element 33 is made of a material with medium-high conductivity, with values indicatively between 100 and 400 W/(mK), high reflection coefficient, low emissivity so as to cool more rapidly when the platforms 12, 13 are opened and a new cycle of loading the objects to be laminated O begins. The second platform 13 can comprise several grid elements 33, each covering a single radiance heater 31 or covering a group thereof. The grid element 33 can also be unique for all radiance heaters 31.

With reference to fig. 8, the grid element 33 is formed by a flat plate 34 provided with a plurality of apertures 35.

The apertures 35 are optimized to allow an effective passage of the infrared waves emitted by the same radiance heaters 31.

The apertures 35 can have a passage gap that is diversified each one from the other, or according to groups, lines, sectors. For example, the apertures 35 can have a circular shape with different diameters. Other shapes are within the scope of the present invention.

This advantageously allows both to direct the passage of the thermal radiation emitted by the radiance heaters 31 in a preferential manner, and also to obtain a certain bending stiffness of the flat plate 34, so as to prevent bending or deformations caused by the interference that can occur with the flexible membrane 14 when the pressure in the lamination chambers 17, 18 is varied.

It is clear that modifications and/or additions of parts may be made to the laminator apparatus 10 as described heretofore, without departing from the field and scope of the present invention, as defined by the claims.

It is also clear that, although the present invention has been described with reference to some specific examples, a person of skill in the art will be able to achieve other equivalent forms of a laminator apparatus, having the characteristics expressed in the claims and hence all coming within the field of protection defined thereby.

In the following claims, the sole purpose of the references in brackets is to facilitate their reading and they must not be considered as restrictive factors with regard to the field of protection defined by the claims.

## Claims

1. Laminator apparatus (10) comprising a support structure (11) on which there are mounted a first and a second horizontal lamination platform (12, 13) facing each other, with interposed a flexible membrane (14), wherein said first platform (12) comprises a plurality of flat heating units (24) on which at least one object to be laminated (O) is able to be disposed, wherein each of said flat heating units (24) is formed by a pair of plates (25, 26) closed one on top of the other, between which there is inserted a plurality of electric resistance flat heaters (27), **characterized in that** each electric resistance flat heater (27) is formed by a sandwich comprising at least two flat layers (27a, 27b), electrically insulating and thermally conductive, between which at least one electrically powered conductive track (27c) is inserted and **in that** one or more of said at least two flat layers (27a, 27b) and said at least one conductive track (27c) are connected in a removable manner in order to be selectively separable.

2. Laminator apparatus (10) as in claim 1, **characterized in that** said plurality of electric resistance flat heaters (27) can be removed from said pair of plates (25, 26).

3. Laminator apparatus (10) as in claim 1 or 2, **characterized in that** said at least two flat layers (27a, 27b) and said at least one conductive track (27c) constitute a single body.

4. Laminator apparatus (10) as in any claim hereinbefore, **characterized in that** each electric resistance flat heater (27) comprises a plurality of distinct conductive tracks (27c), electrically powered independently in order to obtain thermally differentiated zones.

5. Laminator apparatus (10) as in any claim hereinbefore, **characterized in that** said second lamination platform (13) comprises a second frame (30) provided with an upper heating system comprising a plurality of radiance heaters (31) disposed facing said membrane (14) and said object to be laminated (O).

6. Laminator apparatus (10) as in claim 5, **characterized in that** said plurality of radiance heaters (31) is attached to an upper internal wall (30a) of said second frame (30), in a position that is distanced, or up against, or recessed, with respect to said upper internal wall (30a), by means of support elements (32) having an insulating and vibration compensation function.

7. Laminator apparatus (10) as in claim 5, **characterized in that** said plurality of radiance heaters (31) is attached up against said upper internal wall (30a).

8. Laminator apparatus (10) as in claim 5, **characterized in that** said plurality of radiance heaters (31) is recessed in said upper internal wall (30a).

9. Laminator apparatus (10) as in any claim from 5 to 8, **characterized in that** said second lamination platform (13) comprises a flat grid element (33), disposed between said plurality of radiance heaters (31) and said flexible membrane (14).

10. Laminator apparatus (10) as in claim 9, **characterized in that** said grid element (33) is formed by a flat plate (34) provided with a plurality of apertures (35) having a respective passage gap that is either the same as, or diversified, one to each other, with a distribution on the plate that is either uniform or not.

11. Laminator apparatus (10) as in claim 9, **characterized in that** said grid element (33) is formed by a flat plate (34) provided with a plurality of apertures (35) having a respective passage gap that is the same one to each other.

12. Laminator apparatus (10) as in claim 9, **characterized in that** said grid element (33) is formed by a flat plate (34) provided with a plurality of apertures (35) having a respective passage gap that is different one to each other.

13. Laminator apparatus (10) as in claim 9, **characterized in that** said grid element (33) is formed by a flat plate (34) provided with a plurality of apertures (35) having a uniform distribution on the plate.

14. Laminator apparatus (10) as in claim 9, **characterized in that** said grid element (33) is formed by a flat plate (34) provided with a plurality of apertures (35) having a differentiated distribution on the plate.

## Patentansprüche

1. Laminiervorrichtung (10), die eine Stützstruktur (11) umfasst, auf der eine erste und eine zweite horizontale Laminierplattform (12, 13) einander zugewandt montiert sind, mit einer dazwischenliegenden flexiblen Membran (14), wobei die erste Plattform (12) eine Vielzahl von flachen Heizeinheiten (24) umfasst, auf denen mindestens ein zu laminierendes Objekt (O) angeordnet werden kann, wobei jede der flachen Heizeinheiten (24) durch ein Plattenpaar (25, 26) gebildet ist, die übereinander geschlossen sind, zwischen denen eine Vielzahl von elektrischen Widerstandsflachheizeinrichtungen (27) eingefügt sind, **dadurch gekennzeichnet, dass**
jede elektrische Widerstandsflachheizeinrichtung (27) gebildet ist, durch ein Sandwich, das mindestens zwei flache Schichten (27a, 27b) umfasst, die elektrisch isolierend und thermisch leitend sind, zwischen denen mindestens eine elektrisch betriebene, leitfähige Spur (27c) eingefügt ist und dass
eine oder mehrere der mindestens zwei flachen Schichten (27a, 27b) und die mindestens eine leitfähige Spur (27c) in lösbarer Weise verbunden sind, um selektiv trennbar zu sein.

2. Laminiervorrichtung (10) nach Anspruch 1, **dadurch gekennzeichnet, dass**
die Vielzahl von elektrischen Widerstandsflachheizeinrichtungen (27) von dem Plattenpaar (25, 26) entfernt werden kann.

3. Laminiervorrichtung (10) nach Anspruch 1 oder 2, **dadurch gekennzeichnet, dass**
die mindestens zwei flachen Schichten (27a, 27b) und die mindestens eine leitfähige Spur (27c) einen einzigen Körper bilden.

4. Laminiervorrichtung (10) nach einem der vorhergehenden Ansprüche, **dadurch gekennzeichnet, dass**
jede elektrische Widerstandsflachheizeinrichtung (27) eine Vielzahl von verschiedenen leitfähigen Spuren (27c) umfasst, die unabhängig elektrisch betrieben werden, um thermisch differenzierte Zonen zu erhalten.

5. Laminiervorrichtung (10) nach einem der vorhergehenden Ansprüche, **dadurch gekennzeichnet, dass**
die zweite Laminierplattform (13) einen zweiten Rahmen (30) umfasst, der mit einem oberen Heizsystem bereitgestellt ist, das eine Vielzahl von Strahlungsheizeinrichtungen (31) umfasst, die der Membran (14) und dem zu laminierenden Objekt (O) zugewandt angeordnet sind.

6. Laminiervorrichtung (10) nach Anspruch 5, **dadurch gekennzeichnet, dass**
die Vielzahl von Strahlungsheizeinrichtungen (31) an einer oberen inneren Wand (30a) des zweiten Rahmens (30) befestigt sind, in einer Position, die bezüglich der oberen inneren Wand (30a) beabstandet oder anliegend oder vertieft ist, mittels Stützelementen (32), die eine isolierende und schwingungskompensatorische Funktion aufweisen.

7. Laminiervorrichtung (10) nach Anspruch 5, **dadurch gekennzeichnet, dass**
die Vielzahl von Strahlungsheizeinrichtungen (31) anliegend an der oberen inneren Wand (30a) befestigt sind.

8. Laminiervorrichtung (10) nach Anspruch 5, **dadurch gekennzeichnet, dass**
die Vielzahl von Strahlungsheizeinrichtungen (31) in der oberen inneren Wand (30a) vertieft sind.

9. Laminiervorrichtung (10) nach einem der Ansprüche 5 bis 8, **dadurch gekennzeichnet, dass**
die zweite Laminierplattform (13) ein flaches Rasterelement (33) umfasst, das zwischen der Vielzahl von Strahlungsheizeinrichtungen (31) und der flexiblen Membran (14) angeordnet ist.

10. Laminiervorrichtung (10) nach Anspruch 9, **dadurch gekennzeichnet, dass**
das Rasterelement (33) durch eine flache Platte (34) gebildet ist, die mit einer Vielzahl von Öffnungen (35) bereitgestellt ist, die einen jeweiligen Durchgangsspalt aufweisen, der entweder gleich oder verschieden zueinander ist, mit einer Verteilung auf der Platte, die entweder gleichmäßig oder nicht ist.

11. Laminiervorrichtung (10) nach Anspruch 9, **dadurch gekennzeichnet, dass**
das Rasterelement (33) durch eine flache Platte (34) gebildet ist, die mit einer Vielzahl von Öffnungen (35) bereitgestellt ist, die einen jeweiligen Durchgangsspalt aufweisen, der zueinander gleich ist.

12. Laminiervorrichtung (10) nach Anspruch 9, **dadurch gekennzeichnet, dass**
das Rasterelement (33) durch eine flache Platte (34) gebildet ist, die mit einer Vielzahl von Öffnungen (35) bereitgestellt ist, die einen jeweiligen Durchgangsspalt aufweisen, der zueinander verschieden ist.

13. Laminiervorrichtung (10) nach Anspruch 9, **dadurch gekennzeichnet, dass**
das Rasterelement (33) durch eine flache Platte (34) gebildet ist, die mit einer Vielzahl von Öffnungen (35) bereitgestellt ist, die eine gleichmäßige Verteilung auf der Platte aufweisen.

14. Laminiervorrichtung (10) nach Anspruch 9, **dadurch gekennzeichnet, dass**
das Rasterelement (33) durch eine flache Platte (34) gebildet ist, die mit einer Vielzahl von Öffnungen (35) bereitgestellt ist, die eine differenzierte Verteilung auf der Platte aufweisen.

## Revendications

1. Appareil de stratification (10) comprenant une structure de support (11) sur laquelle sont montées une première et une seconde plate-forme de stratification horizontale (12, 13) se faisant face mutuellement, avec interposition d'une membrane flexible (14), dans lequel ladite première plate-forme (12) comprend une pluralité d'unités de chauffage plates (24) sur lesquelles au moins un objet à stratifier (O) peut être disposé, dans lequel chacune desdites unités de chauffage plates (24) est formée par une paire de plaques (25, 26) fermées une sur le dessus de l'autre, entre lesquelles est insérée une pluralité d'éléments chauffants plats à résistance électrique (27), **caractérisé en ce que** chaque élément chauffant plat à résistance électrique (27) est formé par un sandwich comprenant au moins deux couches plates (27a, 27b), électriquement isolantes et thermiquement conductrices, entre lesquelles au moins une piste conductrice alimentée électriquement (27c) est insérée, et **en ce qu'**une ou plusieurs desdites au moins deux couches plates (27a, 27b) et ladite au moins une piste conductrice (27c) sont connectées de manière amovible afin de pouvoir être séparées sélectivement.

2. Appareil de stratification (10) selon la revendication 1, **caractérisé en ce que** ladite pluralité d'éléments chauffants plats à résistance électrique (27) peut être retirée de ladite paire de plaques (25, 26).

3. Appareil de stratification (10) selon la revendication 1 ou 2, **caractérisé en ce que** lesdites au moins deux couches plates (27a, 27b) et ladite au moins une piste conductrice (27c) constituent un corps unique.

4. Appareil de stratification (10) selon l'une quelconque des revendications précédentes, **caractérisé en ce que** chaque élément chauffant plat à résistance électrique (27) comprend une pluralité de pistes conductrices distinctes (27c), alimentées électriquement de manière indépendante afin d'obtenir des zones différenciées thermiquement.

5. Appareil de stratification (10) selon l'une quelconque des revendications précédentes, **caractérisé en ce que** ladite seconde plate-forme de stratification (13) comprend un second cadre (30) pourvu d'un système de chauffage supérieur comprenant une pluralité d'éléments chauffants à rayonnement (31) disposés en face de ladite membrane (14) et dudit objet à stratifier (O).

6. Appareil de stratification (10) selon la revendication 5, **caractérisé en ce que** ladite pluralité d'éléments chauffants à rayonnement (31) est fixée à une paroi interne supérieure (30a) dudit second cadre (30), dans une position distante, ou contre, ou en retrait, par rapport à ladite paroi interne supérieure (30a), par l'intermédiaire d'éléments de support (32) présentant une fonction d'isolation et de compensation de vibrations.

7. Appareil de stratification (10) selon la revendication 5, **caractérisé en ce que** ladite pluralité d'éléments chauffants à rayonnement (31) est fixée contre ladite paroi interne supérieure (30a).

8. Appareil de stratification (10) selon la revendication 5, **caractérisé en ce que** ladite pluralité d'éléments chauffants à rayonnement (31) est en retrait dans ladite paroi interne supérieure (30a).

9. Appareil de stratification (10) selon l'une quelconque des revendications 5 à 8, **caractérisé en ce que** ladite seconde plate-forme de stratification (13) comprend un élément de grille plat (33), disposé entre ladite pluralité d'éléments chauffants à rayonnement (31) et ladite membrane flexible (14).

10. Appareil de stratification (10) selon la revendication 9, **caractérisé en ce que** ledit élément de grille (33) est formé par une plaque plate (34) pourvue d'une pluralité d'ouvertures (35) présentant un espace de passage respectif qui est soit identique, soit diversifié, les uns par rapport aux autres, avec une répartition sur la plaque qui est soit uniforme, soit non uniforme.

11. Appareil de stratification (10) selon la revendication 9, **caractérisé en ce que** ledit élément de grille (33) est formé par une plaque plate (34) munie d'une pluralité d'ouvertures (35) présentant un espace de passage respectif qui est identique par rapport aux autres.

12. Appareil de stratification (10) selon la revendication 9, **caractérisé en ce que** ledit élément de grille (33) est formé par une plaque plate (34) munie d'une pluralité d'ouvertures (35) présentant un espace de passage respectif qui est différent des autres.

13. Appareil de stratification (10) selon la revendication 9, **caractérisé en ce que** ledit élément de grille (33) est formé par une plaque plate (34) pourvue d'une pluralité d'ouvertures (35) présentant une distribution uniforme sur la plaque.

14. Appareil de stratification (10) selon la revendication 9, **caractérisé en ce que** ledit élément de grille (33) est formé par une plaque plate (34) munie d'une pluralité d'ouvertures (35) présentant une distribution différenciée sur la plaque.
